Europäisches Patentamt

European Patent Office

Office européen des brevets

(11) Numéro de publication: **0 394 159**

**A1**

# DEMANDE DE BREVET EUROPEEN

(21) Numéro de dépôt: **90470019.2**

(51) Int. Cl.⁵: **C23C 8/36**

(22) Date de dépôt: **12.04.90**

(30) Priorité: **18.04.89 FR 8905430**
**15.06.89 FR 8908085**

(43) Date de publication de la demande:
**24.10.90 Bulletin 90/43**

(84) Etats contractants désignés:
**AT BE CH DE DK ES GB GR IT LI LU NL SE**

(71) Demandeur: **USINOR SACILOR Société Anonyme**
**La Défense 9, 4, Place de la Pyramide**
**F-92800 Puteaux(FR)**

(72) Inventeur: **De Gelis, Pierre**
**4 Ter, rue Bonnemain**
**F-78104 Saint Germain(FR)**

(74) Mandataire: **Ventavoli, Roger**
**TECHMETAL PROMOTION Domaine de l'IRSID Voie romaine BP 321**
**F-57213 Maizières-lès-Metz Cédex(FR)**

(54) **Procédé de coloration de la surface de matériaux métalliques et produits obtenus par sa mise en oeuvre.**

(57) La présente invention concerne un procédé de coloration de la surface de matériaux métalliques par formation d'une pellicule d'oxydes et les produits ainsi obtenus. Le matériau à colorer est soumis à un traitement superficiel par plasma à basse température dans une atmosphère comprenant au moins un gaz dont la molécule contient des atomes d'oxygène.

L'invention s'applique principalement à la coloration des plaques et des tôles, notamment en acier inoxydable.

EP 0 394 159 A1

# PROCEDE DE COLORATION DE LA SURFACE DE MATERIAUX METALLIQUES ET PRODUITS OBTENUS PAR SA MISE EN OEUVRE

La présente invention concerne un procédé de coloration de la surface de matériaux métalliques par formation d'une pellicule d'oxydes. Elle s'applique avantageusement à la coloration de produits plats, tels que les tôles en acier, notamment en acier inoxydable.

La coloration superficielle des matériaux métalliques, notamment des tôles ou des plaques d'acier inoxydable, trouve ses principales applications dans le domaine du bâtiment. Les pièces ainsi colorées sont utilisées pour les toitures ou le revêtement mural des édifices. Une telle coloration est également appliquée à des éléments de décoration intérieure, à des ensembles de robinetterie, à des articles ménagers divers, etc...

On sait que cette coloration peut être obtenue grâce à la formation d'une pellicule d'oxydes sur la surface du matériau, et à l'établissement de phénomèmes d'interférences lumineuses. Pour un matériau donné, la couleur observée est fonction de l'épaisseur de la pellicule déposée.

Les méthodes de coloration des aciers inoxydables utilisées classiquement consistent à créer cette pellicule d'oxydes par réaction chimique en immergeant le matériau à colorer dans une solution oxydante, telle qu'un bain contenant des ions nitrate, chromate ou permanganate (brevet US-A-4 692 191). Des méthodes électrochimiques peuvent également être employées pour réaliser cette oxydation superficielle.

L'utilisation de tels bains oxydants nécessite cependant des précautions contraignantes pour garantir la sécurité des opérateurs et éviter des pollutions de l'environnement. D'autre part, ces bains sont agressifs vis-à-vis du métal et ne permettent pas toujours de conserver l'état de surface initial du matériau.

Le but de l'invention est de proposer une méthode rapide et non polluante de coloration des matériaux métalliques, notamment d'une tôle en acier inoxydable, qui permet en outre de conserver au matériau à colorer son aspect initial, tel qu'un aspect brillant ou satiné.

A cet effet, l'invention a pour objet un procédé de coloration de la surface d'un matériau métallique par création à la surface dudit matériau d'une pellicule d'oxydes d'épaisseur contrôlée, caractérisé en ce que l'on soumet le matériau métallique à un traitement superficiel par plasma basse température dans une atmosphère compre nant au moins un gaz dont la molécule contient des atomes d'oxygène et au contact avec un matériau-source contenant les éléments dont on veut déposer les oxydes sur le matériau à colorer, ledit matériau-source étant polarisé négativement par rapport au matériau à colorer, et étant placé en regard de la surface du matériau à colorer.

Dans une réalisation préférentielle, le plasma est produit par décharge électroluminescente entre une anode et une cathode, la cathode étant constituée par le matériau-source, et l'anode pouvant être constituée par le matériau à colorer.

Préférentiellement l'atmosphère est constituée par un mélange d'oxygène et d'azote 20-80 % en volume.

Par le terme matériau-source, on désigne une pièce constituant un gisement d'atomes destinés à former, sous forme oxydée, le dépôt sur le matériau à colorer.

Comme on l'aura compris, le procédé consiste à mettre le matériau dans une enceinte contenant un plasma oxydant. Ce plasma arrache des atomes à la surface du matériau-source. Ces atomes se combinent à l'oxygène du plasma et viennent se déposer sur la surface du matériau à colorer. Par suite de phénomènes d'interférences lumineuses, la surface de ce matériau prend une coloration qui est fonction de l'épaisseur de la pellicule d'oxydes ainsi formée, donc de la durée du traitement.

Il est connu de soumettre la surface de matériaux métalliques à un traitement superficiel par plasma dans une atmosphère constituée par un gaz rare, tel que l'argon. Dans un tel traitement, la surface du matériau polarisé négativement est bombardée par des ions du plasma, ce qui provoque un arrachement des atomes superficiels du matériau.

Dans une demande de brevet antérieure (FR-88.05091), au nom de la demanderesse, est exposée une méthode pour l'amélioration de la résistance à la corrosion de matériaux métalliques, dans laquelle le matériau à traiter est placé en cathode dans un plasma obtenu par décharge électroluminescente, donc dans une atmosphère à faible pression (inférieure à 1000 Pa). Le plasma ainsi formé est du type communément appelé plasma "froid" ou "basse température", par opposition aux plasmas de fusion thermonucléaires appelés plasmas "chauds". Son degré d'ionisation est faible ($10^{-7}$ à $10^{-3}$). L'énergie électrique est transférée aux électrons qui sont assez peu nombreux, mais très énergétiques (1 à 10eV). Ils excitent ainsi le gaz à chauffer, dont la température peut aller de 20 à 700° C environ, et produisent des espèces excitées en grand nombre.

L'inventeur a constaté que, dans le cas ou l'atmosphère comporte un gaz oxydant, même à faible teneur, on retrouve sur l'anode une pellicule d'oxydes métalliques formés à partir d'atomes métalliques provenant de la cathode. Cette pellicule colore la surface du matériau grâce à l'établissement d'interférences lumineuses, résultat qui est similaire à celui que l'on obtient par les méthodes chimiques et électrochimiques usuellement employées pour la coloration des matériaux métalliques. De plus, l'opération n'affecte pas l'aspect de surface initial du matériau tel qu'un aspect brillant ou satiné, contrairement aux méthodes précédentes qui impliquent une attaque superficielle du matériau.

Pour obtenir ce dépôt d'oxydes d'une façon contrôlée, un mode opératoire est le suivant. Le matériau métallique, par exemple une plaque en acier inoxydable, que l'on désire colorer superficiellement est placé dans une enceinte. Celle-ci contient un gaz comportant des atomes d'oxygène et capable d'être ionisé par une décharge électroluminescente établie entre une cathode et une anode qui se font face. L'anode est constituée par le matériau à colorer lui-même et la cathode est au contact de l'atmosphère gazeuse de l'enceinte de traitement.

La cathode est constituée par une plaque métallique, en un matériau tel qu'un acier inoxydable ferritique ou austénitique, un acier inoxydable chromé, du titane, de l'aluminium, etc... De manière générale, la nature du matériau de la cathode gouverne la nature des oxydes qui se déposent sur la pièce à colorer. Avec un acier inoxydable ferritique, le dépôt est composé d'oxydes de fer et de chrome. Avec un acier inoxydable austénitique, le dépôt contient également des oxydes de nickel. Avec un acier chromé, le dépôt est constitué essentiellement par des oxydes de chrome. Avec du titane ou de l'aluminium purs, le dépôt est constitué par des oxydes de titane ou d'aluminium. Le choix de la nature des oxydes déposés sur la pièce à colorer dépend des caractéristiques recherchées pour le dépôt telles que son adhérence ou sa résistance à la corrosion.

L'atmosphère dans l'enceinte de traitement est une atmosphère raréfiée, avec une pression inférieure à 1000 Pa. Elle comporte, comme déjà indiqué, au moins, et même seulement à l'état de traces, un gaz présentant un pouvoir oxydant et facilement ionisable, donc choisi par exemple parmi l'oxygène, l'ozone, l'air, le gaz carbonique, les oxydes d'azote, la vapeur d'eau. Les mélanges entre un ou plusieurs de ces gaz et un gaz neutre, tel que l'argon, peuvent également être employés. Dans la pratique, on pourra utiliser de l'air reconstitué, c'est-à-dire un mélange comportant 80 % en volume d'azote et 20 % en volume d'oxygène. L'utilisation d'air naturel simplifie le problème de la mise sous basse pression de l'enceinte.

La couleur qui apparaît à la surface du matériau en anode est fonction de l'épaisseur du dépôt d'oxydes. Cette épaisseur est de l'ordre de quelques centaines d'Angströms et dépend elle-même :

- de la tension maintenue entre anode et cathode pour entretenir la décharge, et qui peut aller de 200 à 5000 V
- de la densité de courant dans l'anode qui peut aller de 1 à 100 mA/cm$^2$
- du temps pendant lequel est effectué le dépôt, qui peut aller jusqu'à 60 minutes
- de la distance entre l'anode et la cathode, qui peut aller de 1 mm à plusieurs centimètres, et préférentiellement de 1 à 50 mm.

Pour des conditions de traitement données, il est aisé de déterminer expérimentalement quelle couleur est obtenue. L'homogénéité de la couleur dépend de l'état de surface du matériau à colorer, de l'homogénéité de sa température, et du bon réglage du parallélisme entre le matériau et la cathode. En revanche, la couleur ne dépend pas de la composition chimique du dépôt.

L'épaisseur d'oxydes augmente si :
- le temps de traitement augmente
- la densité de courant à l'anode augmente
- la tension aux électrodes augmente
- la distance entre les électrodes diminue.

A titre d'exemple, la surface d'une plaque d'acier inoxydable de dimensions de 70 x 120 mm, soumise, dans une atmosphère à 80 % d'azote et 20 % d'oxygène en volume, à un courant d'intensité 300 mA (soit une densité de courant de 3,6 mA/cm$^2$), avec une tension entre électrodes de 1200 V et une distance à la cathode de 10 mm prend les colorations suivantes :
- pour 2 à 4 minutes de traitement : jaune à jaune rosé
- pour 5 à 6 minutes de traitement : rouge-violet
- pour 7 à 12 minutes de traitement : bleu foncé à bleu pâle
- pour 18 minutes de traitement : jaune
- pour 22 minutes de traitement : rose
- pour 27 minutes de traitement : bleu-vert
- pour 30 minutes de traitement : vert
- pour 60 minutes de traitement : rose

Il est possible de dessiner des motifs sur le matériau à colorer grâce à des caches permettant de moduler le temps d'exposition au plasma de différentes plages de l'échantillon, et par là même l'épaisseur d'oxydes qui les recouvre. Des nuances dégradées peuvent être obtenues en disposant la cathode obliquement par rapport à l'échantillon, de manière à faire varier continûment la distance entre les électrodes et donc corrélativement l'épaisseur du dépôt sur l'anode. D'autre part, si on désire obtenir une coloration homogène d'une pièce non plane, il est nécessaire d'employer une cathode de même forme et disposée parallèlement à la pièce à colorer.

Bien entendu, l'invention ne se limite pas à l'exemple qui vient d'être décrit. Ainsi, le matériau à colorer peut être simplement placé en regard du matériau source en cathode, sans être lui-même inclus dans le circuit de production de la décharge électroluminescente. De même, le plasma basse température requis peut être produit par d'autres procédés que la décharge électroluminescente. On peut citer, par exemple, l'excitation de l'atmosphère par micro-ondes ou par radiofréquence. Cependant, il est dans tous les cas nécessaire d'imposer au matériau-source un potentiel inférieur à celui du matériau à colorer.

Bien entendu, la pièce colorée n'est pas normalement destinée à subir ultérieurement un traitement de surface qui viendrait masquer la coloration obtenue. C'est pourquoi l'invention s'applique principalement aux aciers inoxydables, pour lesquels de tels traitements ne sont pas indispensables à une bonne conservation de la pièce en atmosphère ambiante courante.

## Revendications

1) Procédé de coloration de la surface d'un matériau métallique par création à la surface dudit matériau d'une pellicule d'oxydes d'épaisseur contrôlée, caractérisé en ce que l'on soumet le matériau métallique à un traitement superficiel par plasma à basse température dans une atmosphère comprenant au moins un gaz dont la molécule contient des atomes d'oxygène et au contact avec un matériau-source contenant les éléments dont on veut déposer les oxydes sur le matériau à colorer, ledit matériau source étant polarisé négativement par rapport au matériau à colorer.

2) Procédé selon la revendication 1, caractérisé en ce que le plasma à basse température est produit par décharge électroluminescente entre une anode et une cathode, la cathode étant constituée par le matériau source.

3) Procédé selon la revendication 2, caractérisé en ce que l'anode est constituée par le matériau à colorer.

4) Procédé selon l'une des revendications 1 à 3, caractérisé en ce que ledit gaz est choisi parmi l'oxygène, l'ozone, l'air, les oxydes d'azote, la vapeur d'eau et les mélanges de ceux-ci avec un gaz neutre.

5) Procédé selon la revendication 2 ou 3, caractérisé en ce que l'on opère sous une tension de 200 à 5000 V.

6) Procédé selon l'une quelconque des revendications 2, 3 ou 5 caractérisé en ce qu'on établit une densité de courant à l'anode de 1 à 100 mA/cm$^2$.

7) Procédé selon l'une quelconque des revendications 1 à 6, caractérisé en ce qu'on maintient une distance entre le matériau-source et le matériau à colorer de 1 à 50 mm.

8) Produit métallique coloré superficiellement par une pellicule d'oxydes, caractérisé en ce que ladite pellicule est formée par exposition du matériau à colorer à un plasma basse température dans une atmosphère comprenant au moins un gaz dont la molécule contient des atomes d'oxygène et au contact avec un matériau-source contenant les éléments dont on veut déposer les oxydes sur le matériau à colorer, ledit matériau-source étant polarisé négativement par rapport au matériau à colorer.

9) Produit métallique selon la revendication 8 caractérisé en ce qu'il est constitué par une plaque ou une tôle.

10) Produit métallique selon la revendication 8 ou 9 caractérisé en ce qu'il est en acier inoxydable.

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | FR-A-2 093 728 (XEROX CORP.) * Page 2, lignes 27-37; page 4, lignes 22-30; revendications 1-5 * | 1-6,8 | C 23 C 8/36 |
| A | FR-A-2 356 742 (NIPPON TELEGRAPH AND TELEPHONE CORP.) * Revendications 1-3 * | 1-4,8 | |
| A | US-A-4 704 199 (T. YOKOKAWA, Y. HIRUKAWA) * Colonne 3, lignes 26-55 * | 1-4,8 | |
| A | CHEMICAL ABSTRACTS, vol. 101, no. 20, novembre 1984, page 254, résumé no, 175457k, Columbus, Ohio, US; S.R. PUSTOTINA et al.: "Study of the surface of steel St3 treated in a glow-discharge plasma", & ELEKTRON. OBRAB. MATER. 1984, (3), 38-40 * Résumé * | 1,5,6,8 -10 | |
| A | PATENT ABSTRACTS OF JAPAN, vol. 10, no. 362 (C-389)[2419], 4 décembre 1986; & JP-A-61 157 671 (SUMITOMO METAL IND. LTD) 17-07-1986 * Résumé * | 1,8 | DOMAINES TECHNIQUES RECHERCHES (Int. Cl.5)<br><br>C 23 C |
| A | CHEMICAL ABSTRACTS, vol. 84, no. 11, mars 1976, page 292, résumé no. 78400j, Columbus, Ohio, US; & JP-A-75 98 451 (SUWA SEIKOSHA CO., LTD) 05-08-1975 . * En entier * | 1,8 | |

Le présent rapport a été établi pour toutes les revendications

| Lieu de la recherche | Date d'achèvement de la recherche | Examinateur |
|---|---|---|
| LA HAYE | 26-07-1990 | JOFFREAU P.O. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)